(19) Europäisches Patentamt / European Patent Office / Office européen des brevets

(11) **EP 2 427 714 B1**

(12) **FASCICULE DE BREVET EUROPEEN**

(45) Date de publication et mention de la délivrance du brevet:
**03.04.2013 Bulletin 2013/14**

(21) Numéro de dépôt: **10715899.0**

(22) Date de dépôt: **05.05.2010**

(51) Int Cl.:
*F28D 21/00* *(2006.01)*  *F28F 13/00* *(2006.01)*
*F28F 13/18* *(2006.01)*  *H01L 23/427* *(2006.01)*

(86) Numéro de dépôt international:
**PCT/EP2010/056071**

(87) Numéro de publication internationale:
**WO 2010/128067 (11.11.2010 Gazette 2010/45)**

(54) **DISPOSITIF D'ECHANGE THERMIQUE A COEFFICIENT D'ÉCHANGE THERMIQUE AUGMENTÉ ET PROCÉDÉ DE RÉALISATION D'UN TEL DISPOSITIF**

WÄRMEAUSTAUSCHSSYSTEM MIT VERBESSERTEM WÄRMEAUSTAUSCHGRAD UND DESSEN HERSTELLUNGSPROZESS

HEAT EXCHANGE APPARATUS WITH IMPROVED HEAT EXCHANGE RATE AND ITS FABRICATION PROCESS

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **06.05.2009 FR 0953012**

(43) Date de publication de la demande:
**14.03.2012 Bulletin 2012/11**

(73) Titulaire: **Commissariat à l'Énergie Atomique et aux Énergies Alternatives**
**75015 Paris (FR)**

(72) Inventeurs:
• **PHAN, Hai, Trieu**
  **38000 Grenoble (FR)**
• **GAVILLET, Jérôme**
  **F-38120 Saint-Egreve (FR)**

(74) Mandataire: **Ilgart, Jean-Christophe et al**
**BREVALEX**
**95 rue d'Amsterdam**
**75378 Paris Cedex 8 (FR)**

(56) Documents cités:
EP-A1- 0 002 996    WO-A1-2008/090726
WO-A2-02/23115     JP-A- 60 064 194
US-A- 4 050 507

**Description**

**DOMAINE TECHNIQUE ET ART ANTÉRIEUR**

La présente invention se rapporte à un procédé de réalisation de surfaces offrant un coefficient d'échange thermique augmenté et à un dispositif d'échange thermique comportant de telles surfaces. WO 2008/090726 divulgue un dispositif d'échange thermique selon le préambule de la revendication 1.

La miniaturisation des composants électroniques, et notamment des composants de puissance, pose le problème de l'intégration des dispositifs de dissipation de la chaleur émise par ces composants. Dans le domaine de la microélectronique et de l'électronique de puissance, les flux thermiques à dissiper sont de plus en plus élevés et nécessitent une réduction toujours plus grande de la résistance thermique. Les flux thermiques à évacuer ont souvent des valeurs moyennes autour de 150-200 W/cm$^2$, mais peuvent atteindre 1000 W/cm$^2$. Pour ces niveaux de densité de flux de chaleur, les méthodes de refroidissement dites passives, comme les dissipateurs à ailettes ou les systèmes liquides monophasiques atteignent rapidement leur limite de puissance à extraire.

D'autres solutions ont donc été imaginées comme les transferts de chaleur diphasiques liquide/vapeur. Les technologies mettant en oeuvre ces transferts sont le caloduc, le thermosiphon, les boucles capillaires ou à pompage diphasique. Le composant à refroidir est situé sur la zone froide du dispositif de refroidissement, i.e. l'évaporateur.

Les caloducs permettent d'augmenter la conductivité thermique d'un dissipateur de chaleur. Les caloducs permettent le transfert d'une puissance thermique extraite d'une surface donnée vers une surface secondaire, souvent plus accessible ou offrant de meilleurs échanges de chaleur pour la dissipation. Le caloduc est un système clos dans lequel est placé un fluide liquide en équilibre avec sa vapeur. Le caloduc comporte une zone formant évaporateur du côté du composant électronique, où est absorbée la chaleur à dissiper par formation de vapeur. La vapeur produite à l'évaporateur migre à travers le coeur du caloduc jusqu'à une zone de condensation où la chaleur absorbée est relâchée par liquéfaction de la vapeur, la chaleur est donc évacuée. Le condensat retourne vers la zone d'évaporation grâce aux forces capillaires.

Le caloduc peut être rapporté sur le composant électronique ou intégré sur le composant, dans le cas des puces microélectroniques, cela consiste à implanter un réseau de canaux directement sur le substrat en silicium, réduisant ainsi la résistance thermique.

Une autre solution encore est le système de pompage diphasique utilisant un système moteur, un condenseur et un évaporateur.

Toutes ces solutions utilisent donc une surface d'échange thermique en contact avec le composant, soit rapportée sur le composant à refroidir, soit formée dans le substrat du composant à refroidir, cette surface étant destinée à extraire la chaleur générée dans le composant. Cette extraction, comme expliquée ci-dessus, s'effectue par un changement de phase par évaporation d'un liquide.

Le refroidissement recherché a lieu de préférence avec un faible écart de température.

Deux possibilités existent alors pour augmenter les densités de flux thermique transférées, soit augmenter la surface d'échange thermique, soit augmenter le coefficient d'échange thermique. Du fait des problèmes d'encombrement liés à une recherche permanente de miniaturisation et des coûts de production, on privilégie l'augmentation du coefficient d'échange thermique.

Cette augmentation du coefficient d'échange thermique est obtenue en favorisant la nucléation de bulles de vapeur et l'apparition d'un grand nombre de bulles de vapeur provoquant l'évacuation de la chaleur. De préférence, on cherche à obtenir une nucléation avec une surchauffe faible de la surface pour éviter un endommagement du composant à refroidir. La formation de germes de vapeur est favorisée par une surface offrant une faible mouillabilité. Par contre, le détachement des bulles de vapeur est favorisé par une surface présentant une bonne mouillabilité. Par conséquent, on cherche à concilier sur une même surface des propriétés de bonne et de faible mouillabilité.

La solution privilégiée est de créer des sites de nucléation en piégeant du gaz dans des cavités situées entre la surface et le liquide. Ces réservoirs de gaz facilitent l'apparition de germes de vapeur qui, en croissant, se transforment en bulles de vapeur.

Le document « Designing Superoleophobic Surfaces », Anish Tuteja and al. in Science 318, 1618 (2007, pages 1619 à 1622, décrit la réalisation de cavités, dites réentrantes dans la surface, ces cavités sont interconnectées.

Le document « Nucleate Pool Boiling on Structured Enhanced Tubes having Pores with Connecting Gaps », Nae-Hyun Kim, Kuk-Kwang Cj oi, In t . J. Heat and Mass Transfer, Second Edition, Taylor & Francis, 2005, décrit également des cavités réentrantes interconnectées.

Du fait de l'interconnexion des cavités, il existe un risque important de remplissage des cavités par l'eau. Dans ce cas, les cavités sont noyées, ce qui empêche l'apparition de germes de vapeur.

C'est par conséquent un but de la présente invention d'offrir une surface d'échange thermique dont le coefficient d'échange thermique est amélioré.

C'est également un but de la présente invention d'offrir un procédé de réalisation d'une telle surface d'échange thermique.

## EXPOSÉ DE L'INVENTION

Le but précédemment énoncé est atteint par un dispositif d'échange thermique comportant une première face destinée à être en contact avec une source de chaleur à évacuer et une deuxième face destinée à être en contact avec un liquide, ledit dispositif comportant dans son épaisseur entre la première et la deuxième face, une pluralité de cavités séparées les unes des autres, et débouchant dans la deuxième face par au moins un conduit. Les dimensions de chaque conduit, tant au niveau de leur dimension longitudinale que de leur dimension transversale, sont telles qu'ils forment une barrière au liquide, le ménisque se situant dans le conduit, le liquide est donc empêché de pénétrer dans la cavité. Par ailleurs la surface en contact avec le liquide présente des qualités hydrophiles et la surface intérieure des conduits et des cavités présentent des qualités hydrophiles moindres par rapport à celles de la surface en contact avec le liquide.

Ainsi les cavités ne sont pas noyées et le gaz piégé dans les cavités permet la formation de germes de vapeur. Par ailleurs, la réalisation de cavités discrètes, i.e. la présence de matière solide, thermiquement plus conductrice sur le gaz, entre les cavités empêche l'apparition d'une nappe de vapeur continue qui agirait comme une barrière thermique conduisant alors à un échauffement de la structure.

En d'autres termes, on stratifie la surface d'échange thermique, celle-ci comporte une première couche à proximité de la source de chaleur, munie de cavités dans lesquelles la vapeur est piégée et une deuxième couche en contact avec le liquide de refroidissement, percée de conduits reliant les cavités à l'extérieur, un germe de vapeur apparaît, croît et sort de la cavité pour former une bulle de vapeur en surface qui va à son tour croître et se détacher de la surface grâce à la surface hydrophile.

Le conduit peut avoir une géométrie tronconique, son petit diamètre intersectant la cavité, ou une géométrie tubulaire de diamètre inférieur à celui de la cavité pour former une restriction.

La présente invention a alors principalement pour objet un dispositif d'échange thermique comportant une première face destinée à être en contact avec une source de chaleur à évacuer et une deuxième face destinée à être en contact avec un liquide de refroidissement, ledit dispositif comportant dans son épaisseur entre la première et la deuxième face, une pluralité de cavités de rayon moyen, dans lequel :

- lesdites cavités sont isolées les unes des autres de manière fluidique par des parois, chaque cavité débouchant dans la deuxième face par au moins un conduit, chaque conduit présentant une longueur supérieure au rayon moyen des conduits, et la dimension transversale du conduit au niveau de la connexion avec la cavité étant choisie de sorte à former une restriction entre la cavité et le conduit, la deuxième face étant percée d'orifices formés par les conduits, et dans lequel,
- ladite deuxième face présente des propriétés de bonne mouillabilité vis-à-vis du liquide de refroidissement telle que l'angle de contact du liquide soit inférieur à 90° et l'angle de contact entre le liquide et les surfaces intérieures des conduits et des cavités est supérieur ou égal à celui entre le liquide et la deuxième face.

Avantageusement, les conduits présentent un diamètre maximal compris entre $0,1D_1$ et $D_1$ et le nombre de conduits (10) est défini tel que $n > 0,5 \times (D_1/D_2)^2$.

De manière particulièrement, on choisit $V_{total\ conduits} > (P/P_{atm}) \times V_{cavité}$,

- $V_{total}$ conduits étant le volume formé par la somme des volumes de chacun des conduits pénétrant dans une cavité,
- $V_{cavité}$ étant le volume d'une cavité,
- P étant la pression absolue de liquide de refroidissement,
- $P_{atm}$ étant la pression atmosphérique.

Par exemple, les parois séparant les cavités présentent une épaisseur minimale comprise entre 0,1 fois et 0,2 fois le diamètre moyen des cavités, et les orifices formés dans la deuxième face sont séparés d'une distance faible par rapport au diamètre des orifices.

De manière particulièrement avantageuse, les conduits présentent une forme tronconique dont la plus petite base est située au niveau de la connexion avec les cavités.

Par exemple, le dispositif d'échange thermique comporte une matrice dans laquelle les cavités et les conduits sont réalisés et une couche déposée sur la deuxième face, ladite matrice présentant une faible mouillabilité vis-à-vis du liquide et ladite couche présentant une bonne mouillabilité vis-à-vis du liquide.

On peut prévoir que le dispositif d'échange thermique comporte des zones munies d'orifices formés par les conduits débouchant dans la deuxième face, dites zones structurées, et des zones exemptes d'orifices, dites zones non structurées. Par exemple, les zones structurées ont un côté mesurant entre 10 μm et 50 μm, lesdits zones étant séparées les unes des autres d'une distance comprise entre 50 μm et 500 μm.

La présente invention a également pour objet un procédé de réalisation d'un dispositif d'échange thermique selon la présente invention, dans lequel les cavités sont obtenues par le dépôt d'éléments discrets sur un substrat, par enfouissement des ces éléments discrets dans une couche de matériau formant la matrice du dispositif d'échange thermique, de réalisation dans la matrice de conduits jusqu'aux éléments discrets et d'élimination desdits éléments discrets.

Le procédé peut comporter les étapes de :

 a) dépôt sur un substrat d'une couche barrière,
 b) dépôt d'une couche d'éléments discrets de plus grand diamètre moyen destinées à délimiter les cavités,
 c) dépôt d'une couche sur et entre les éléments discrets de plus grand diamètre moyen, ladite couche étant destinée à former la matrice du dispositif,
 d) dépôt d'éléments discrets de plus petit diamètre moyen sur la couche formant matrice,
 e) dépôt d'une couche continue sur et entre les éléments discrets de plus petit diamètre moyen (30),
 f) retrait des éléments discrets de plus petit diamètre moyen laissant apparaître des lumières au niveau desquelles la couche formant matrice est découverte,
 g) réalisation des conduits dans la couche formant matrice au niveau des lumières jusqu'aux éléments discrets de plus grand diamètre moyen,
 h) suppression des éléments discrets de plus grand diamètre moyen.

Les éléments discrets sont par exemple en silice ou en polymère, par exemple en polystyrène, et la suppression des éléments discrets est obtenue par dissolution de ceux-ci par attaque chimique.

Les éléments discrets de plus petit diamètre moyen ont par exemple un diamètre moyen inférieur ou égal au diamètre moyen des éléments discrets de plus grand diamètre

Le Procédé de réalisation d'un dispositif d'échange thermique selon la présente invention peut comporter une étape de réduction de la taille des éléments discrets de plus grand diamètre moyen avant l'étape c) le dépôt et /ou une étape de réduction de la taille des éléments discrets de plus petit diamètre moyen avant l'étape e), par exemple par gravure sèche.

La couche déposée à l'étape e) présente avantageusement une bonne mouillabilité vis-à-vis du liquide de refroidissement, par exemple de la silice.

Le matériau formant la matrice est pat exemple du carbone amorphe hydrogénée.

Le procédé de réalisation d'un dispositif d'échange thermique selon la présente invention peut comporter préalablement à l'étape b), une étape de dépôt d'une précouche du matériau formant la matrice.

Le procédé de réalisation d'un dispositif d'échange thermique la présente invention eut également comporter une étape de mise en place d'un masque sur l'empilement avant l'étape f) de retrait des éléments discrets de plus petit diamètre de sorte à ne permettre un retrait des éléments discrets de plus petit diamètre moyen qu'au niveau des zones non masquées.

BRÈVE DESCRIPTION DES DESSINS

La présente invention sera mieux comprise à l'aide de la description qui va suivre et des dessins en annexes sur lesquels :

-  la figure 1A est une vue en coupe longitudinale en perspective d'un exemple de réalisation d'une portion d'un dispositif d'échange thermique selon la présente invention,
-  la figure 1B est une vue de détail de la figure 1A,
-  la figure 2 est une vue en coupe longitudinale en perspective d'un autre exemple de réalisation d'une portion d'un dispositif d'échange thermique selon la présente invention,
-  les figures 3A à 3C sont des schémas du principe de fonctionnement du dispositif d'échange thermique selon la présente invention,
-  la figure 4 est une vue de dessus d'un dispositif selon la présente invention avec une structuration partielle,
-  les figures 5A à 5I sont des représentations schématiques des différentes étapes de réalisation d'un dispositif d'échange thermique selon la présente invention,
-  la figure 6 est une représentation schématique d'une variante de l'étape représentée sur la figure 5C,
-  les figures 7A et 7B sont des représentations schématiques en coupe et de dessus d'un dispositif d'échange thermique selon la présente invention muni de zones structurées et de zones non structurées.

## EXPOSÉ DÉTAILLÉ DE MODES DE RÉALISATION PARTICULIERS

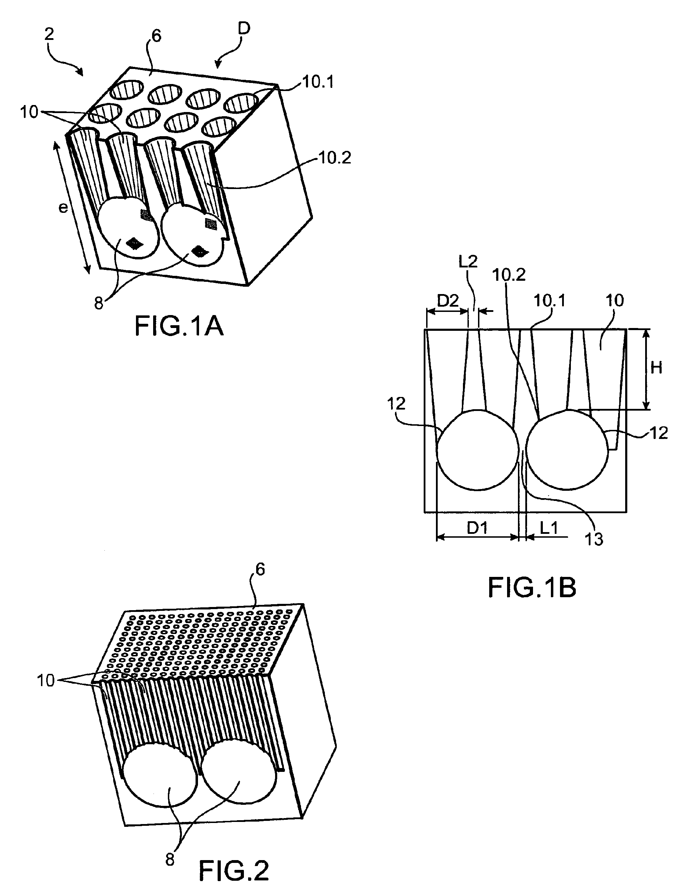

Les figures 1A, 1B et 2 sont des vues en coupe, cependant les hachures ne sont pas représentées.

Sur les figures 1A et 1B, on peut voir un premier exemple de réalisation d'un dispositif d'échange thermique D selon la présente invention.

Un tel dispositif, généralement appelé surface d'échange thermique, se présente sous la forme d'une plaque 2 pouvant être plane ou ayant un profil adapté à la zone à refroidir.

Pour la description nous nous limiterons à une plaque plane, mais il est bien entendu que toute forme de plaque entre dans le cadre de la présente invention.

La plaque 2 comporte une première face 4 destinée à venir en contact avec la source de chaleur à évacuer et une deuxième face 6 destinée à venir en contact avec un liquide, dont l'ébullition permet l'évacuation de la chaleur.

La première 4 et la deuxième 6 faces sont séparées d'une distance e, formant l'épaisseur e de la plaque.

Selon la présente invention, la plaque 2 comporte des cavités 8 situées du côté de la première face 4 à proximité de la source de chaleur et donc à une certaine distance de la deuxième face 6, chaque cavité 8 est reliée à la deuxième face 6 par au moins un conduit 10. Les conduits 10 forment une barrière à la pénétration du liquide dans les cavités.

La taille des cavités 8 est choisie de sorte à être supérieure ou égale à la taille critique d'un germe de vapeur, pour favoriser sa croissance.

Les conduits présentent une dimension longitudinale ou longueur séparant la face 6 de la cavité 8 désignée H. Les conduits 10 débouchent dans la face 6 des ouvertures 11 de diamètre $D_2$.

On choisit la longueur H de sorte que la distance à parcourir par le liquide entre deux extrémités diamétralement opposées des orifices 11 soit supérieure à la longueur H afin de favoriser le mouillage transversale du conduit par rapport au mouillage longitudinale, ce qui réduit les risques des noyer la cavité 8. La longueur H est donc supérieure au diamètre $D_2$.

On cherche à éviter de noyer entièrement la cavité, cependant il reste acceptable qu'une partie de la cavité soit noyée, laissant un volume libre suffisant pour la formation d'un germe de vapeur.

De manière avantageuse, on prévoit de dimensionner les conduits et les cavités pour que les conduits 10 forment une barrière à la pénétration du liquide dans les cavités et empêchent le liquide d'entrée dans les cavités pour une pression absolue de liquide P donnée. Dans ce cas, le volume total des conduits débouchant sur la cavité est choisi supérieur au volume de la cavité selon l'expression ci-dessous afin d'éviter de noyer même partiellement la cavité :

$$V_{total\ conduits} > (P/P_{atm}) \times V_{cavité}.$$

- $V_{total}$ conduits étant le volume formé par la somme des volumes de chacun des conduits 10 pénétrant dans une cavité 8,
- $V_{cavité}$ étant le volume d'une cavité 8,
- P étant la pression absolue de liquide,
- $P_{atm}$ étant la pression atmosphérique.

Ceci présente l'avantage de permettre de réaliser des cavités plus petites dont le volume correspond sensiblement à la taille critique d'un germe de vapeur.

Dans l'exemple représenté sur les figures 1A et 1B, ce sont environ quatre conduits qui relient chaque cavité à la deuxième face 6. En effet, ce n'est pas nécessairement toute la section de chaque conduit qui intercepte la cavité.

Selon l'invention également, chaque cavité 8 est séparée physiquement des autres cavités 8, i.e. il n'y a pas de connexion fluidique entre elles. Les cavités munies de leurs conduits 10 sont séparées les unes des autres par des parois 13 présentant une épaisseur $L_1$ entre les cavités 8, et une épaisseur $L_2$ entre les orifices 11.

Les cavités 8 sont destinées à être remplies de vapeur, par conséquent chaque cavité munie de ses conduits forme un réservoir de vapeur. La présence des parois 13 entre chaque réservoir de vapeur permet d'éviter l'apparition d'une couche de vapeur qui empêcherait l'évacuation de la chaleur de se faire. Les parois permettent une évacuation de chaleur en permanence par conduction.

En outre, la zone de raccordement 12 entre chaque conduit 10 et la cavité associée 8 se présente sous la forme d'un étranglement. Pour cela, le diamètre de la partie du conduit intersectant la paroi de la cavité est inférieur à celui de la cavité.

Par ailleurs, la surface 6 offre des propriétés de bonne mouillabilité vis-à vis de liquide de refroidissement, i.e. l'angle de contact $\alpha$ est inférieur à 90°. Dans le cas de l'eau, la surface est dite hydrophile. La surface intérieure des cavités 8 et la surface intérieure des conduits 10 présentent des propriétés de mouillabilité au plus identiques à celles de la surface 6, c'est-à-dire que l'angle de mouillage sur les surfaces intérieures des cavités et des conduits est supérieur

ou égal à $\alpha$.

Par conséquent, on peut utiliser un matériau hydrophile pour réaliser le dispositif, la surface 6 et les surfaces intérieures des cavités et des conduits présentant alors la même mouillabilité. De manière alternative et particulièrement avantageuse, on peut utiliser un matériau hydrophobe pour réaliser le dispositif et prévoir un traitement hydrophile en surface pour la face 6, la face 6 présentant une bonne mouillabilité et les surfaces intérieure des cavités et des conduits présentant une hydrophobie moindre, donc une mouillabilité moindre. Dans ce dernier cas, la germination et le détachement des bulles sont donc particulièrement favorisés.

Dans l'exemple représenté, les conduits 10 présentent une forme tronconique dont la plus grande base 10.1 forme l'orifice 11 et la plus petite base 10.2 se raccorde à la cavité.

Des conduits ayant une forme tubulaire de diamètre constant ne sortent, cependant, pas du cadre de la présente invention.

De plus, sont représentés des cavités de forme sphérique, cependant l'invention s'applique à des cavités de forme quelconque. Le diamètre indiqué correspond à un diamètre moyen.

La présence de cette restriction entre la cavité 8 et le conduit 10 et le rapport de volume associé ($V_{total\ conduits}/V_{cavité}$) permettent d'éviter au liquide de refroidissement de pénétrer dans la cavité 8. La différence de mouillabilité entre la face 6 et le conduit 10 ainsi que la force résultant de la différence de pression entre le liquide et la vapeur s'opposent toutes deux avantageusement à la pénétration du liquide dans la cavité.

Le diamètre moyen de la cavité 8 est désigné $D_1$. Le diamètre des orifices 11 est désigné $D_2$.

Dans l'exemple des figures 1A et 1B, $D_2$ est égal à $0,5D_1$.

Sur la figure 2, on peut voir un autre exemple de réalisation d'un dispositif d'échange thermique selon la présente invention, dans lequel le diamètre des conduits 10 reliant la cavité 8 à la deuxième face 6 est sensiblement réduit et leur nombre est sensiblement augmenté par rapport au dispositif des figures. Dans cet exemple $D_2$ est environ égal à $01D_1$.

De manière avantageuse, $D_2$ est compris entre $0,1D_1$ et $D_1$ ; $L_2$ est non nul mais très inférieur à D2 préférentiellement inférieure à $0,25D_2$ et la longueur H est supérieure à D2. Dans le cas où $D_2 = D_1$, les conduits 10 seront de préférence tronconique pour délimiter effectivement un étranglement.

On cherche par ailleurs de manière préférentielle à avoir un taux d'ouverture de la face 6 supérieure à 50 %, i.e. le rapport entre la surface des trous 11 et la surface totale de la face 6 est supérieur à 0,5. Ce taux d'ouverture est directement lié au nombre de conduits 10. Avantageusement on choisit un nombre n de conduits tel que :

$$n > 0,5 \times (D1/D2)^2.$$

A titre d'exemple, $D_1$ peut être compris entre 0,5 $\mu$m et 5 $\mu$m, $D_2$ peut donc être compris entre 0,1 $\mu$m et 5 $\mu$m, $L_2$ peut-être comprise entre 0,1 $\mu$m et 1 $\mu$m, $L_1$ est compris entre 0,1 $\mu$m et 0,5 $\mu$m et H est compris entre 0,2 $\mu$m et 30 $\mu$m et supérieur à D2.

Les cavités selon la présente invention peuvent être réalisées dans toute la surface du dispositif d'échange thermique. Par conséquent, toute la face 6 comportera des orifices 11. Cette structuration peut alors atteindre plusieurs cm$^2$.

On peut également prévoir de ne réaliser des cavités qu'à des endroits localisés où l'on sait par exemple que la quantité de chaleur à extraire est plus importante.

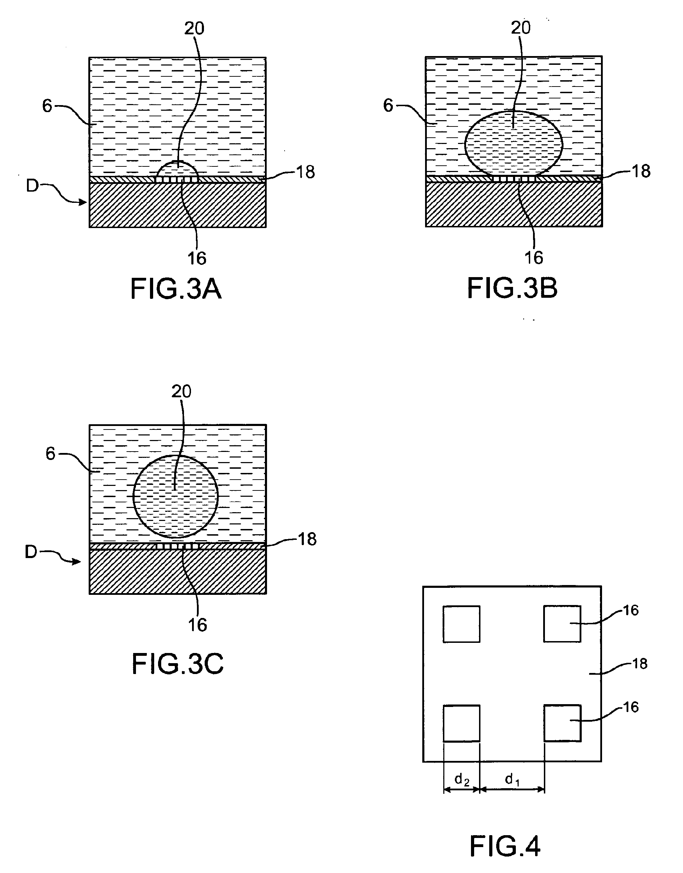

Il peut être préférable de réaliser des zones structurées 16 correspondant sensiblement à la taille d'une bulle de vapeur, i.e. inférieure à environ 1 mm, entourée d'une zone non structurée 18 de sorte que chaque zone structurée 16 formée par ensemble de cavités génère une bulle à la fois. La zone non structurée 18 présente une bonne mouillabilité, elle facilite donc le décrochage de la bulle. Par contre, le nombre de bulles générées est plus faible. Un exemple d'une telle surface est représenté sur la figure 4. La distance $d_1$ entre deux zones structurées 16 est par exemple comprise entre 50 $\mu$m et 500 $\mu$m, et la largeur $d_2$ des zones structurées 16 de forme carrée est par exemple comprise entre 10 $\mu$m et 50 $\mu$m.

Dans le cas où toute la surface est structurée, le nombre de bulles structurées est très grand, par contre leur détachement peut être moins aisé. Il est à noter que dans tous les cas, les orifices des conduits 10 débouchant dans la face 6 sont toujours entourés d'une zone exempte de trous, ce qui assure la présence de liquide favorisant le décrochement de bulles, et le remouillage de la surface, évitant de dégrader le flux critique d'ébullition. Cette zone est plus ou moins grande selon le mode de réalisation.

Nous allons maintenant expliquer le fonctionnement du dispositif selon la présente invention à l'aide des schémas 3A à 3C.

Sur les figures 3A à 3C, on peut voir schématisé un dispositif d'échange thermique D selon la présente invention en contact par sa première face 4 avec un élément à refroidir 14 et par sa deuxième 6 avec un liquide L, par exemple de l'eau.

Le dispositif D comporte une zone structurée 16 telle que représentée sur les figures 1A et 1B ou 2, et une zone non structurée 18, i.e. exempte de cavité.

La chaleur traverse la plaque 2 par conduction. Le liquide en contact avec la face 6 se vaporise partiellement, la vapeur se trouve piégée dans les cavités 8. Du fait de la configuration du conduit, le liquide ne pénètre pas dans la cavité, le ménisque de liquide se trouvant à l'intérieur des conduits 10. Des germes de vapeur apparaissent dans les cavités. La pression dans les cavités augmente, la taille de la cavité étant supérieure à la taille critique de germination, les germes grandissent et montent dans les conduits 10 jusqu'à la surface 6. A la surface, les germes se regroupent pour former une bulle 20 qui continue à croître. La bulle 20 recouvre alors l'ensemble de la zone structurée comme on peut le voir sur la figure 3A.

Le liquide en contact avec la bulle de vapeur se vaporise, ce qui provoque une croissance de la bulle comme on peut le voir sur la figure 3B. Cette bulle, en grossissant, déborde de la zone structurée 16 peu mouillante et entre en contact avec la zone non-structurée 18 qui est au contraire très mouillante. La grande mouillabilité de la zone non-structurée 18 vis-à-vis du liquide provoque une diminution de l'angle de contact entre la bulle vapeur et la deuxième face 6 et une accélération de l'avancement du liquide vers l'axe de la bulle, ceci a pour effet d'induire le détachement de la bulle de vapeur.

Ainsi, grâce à l'invention, l'énergie nécessaire pour activer la nucléation est fortement réduite, la génération de bulles de vapeur est alors favorisée. Leur détachement est également favorisé par la présence de zones mouillantes autour des conduits.

On peut envisager un dispositif dans lequel on prévoit que chaque cavité 8 reliée à la face 6 par un ou plusieurs conduits 10 produise seule une bulle de vapeur. Cependant il est avantageux d'utiliser plusieurs cavités pour produire une bulle. En effet, il existe un risque qu'une cavité soit remplie de liquide et que donc elle ne comporte pas de gaz. Dans ce cas la germination est très difficile. Cette cavité ne produit donc pas ou très peu de bulles. Ce remplissage peut être du à un défaut de la cavité suite à sa réalisation. Au contraire si l'on prévoit que plusieurs cavités soient à l'origine d'une bulle, dans tous les cas, on est sûr que, même si l'une d'entre elles présente un défaut, les autres formeront des sites de germination fonctionnels.

Nous allons maintenant décrire un exemple de procédé de réalisation de telles cavités.

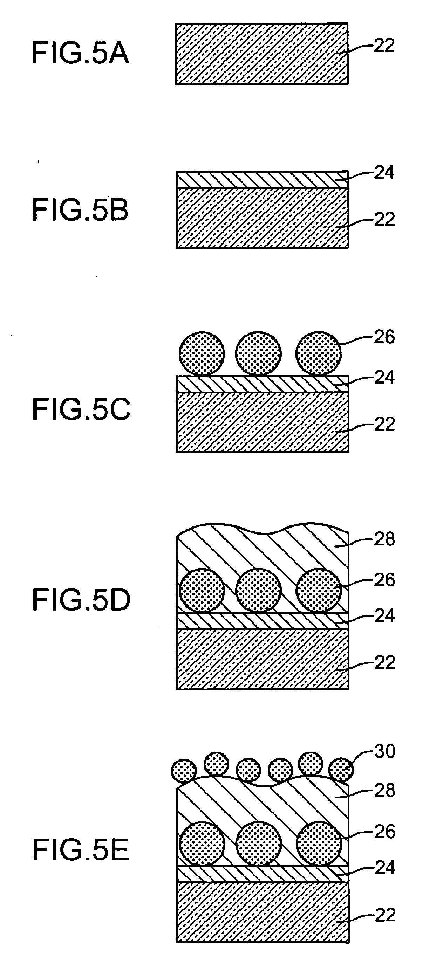

Sur les figures 5A à 5I, on peut voir représentées schématiquement les différentes étapes d'un procédé de réalisation selon la présente invention d'un dispositif d'échange thermique selon la présente invention.

Lors d'une première étape (figure 5A), on choisit un substrat 22 sur lequel les cavités seront réalisées. Ce substrat peut être métallique, par exemple en aluminium, en cuivre, en un alliage ou en silicium. Ce substrat 22 forme l'élément duquel la chaleur doit être évacuée.

Lors d'une étape suivante représentée sur la figure 5B, on dépose une couche barrière 24 sur une face du substrat 22. Cette couche 24 est destinée à assurer l'adhésion de la couche dans laquelle les cavités seront réalisées, qui peut être une couche de carbone sous forme de carbone amorphe hydrogéné (ou DLC : Diamond-like-carbon en terminologie anglosaxonne). Le matériau constituant la couche 24 est choisi pour résister aux attaques chimiques ultérieures, et tel que sa vitesse de gravure soit très inférieure à celle des billes destinés à délimiter les cavités comme nous le verrons par la suite. Ceci permet d'éviter le délaminage de la couche de DLC.

La couche barrière 24 est par exemple en carbure de silicium (Sic) ou en Nichrome (NiCr), déposée par dépôt chimique en phase vapeur ou par dépôt physique en phase vapeur. Son épaisseur est comprise entre 100 nm et 500 nm.

Lors d'une étape suivante représentée sur la figure 5C, on dépose une couche de billes 26 sur la couche 24 formant une épaisseur de billes. Le dépôt de ces billes est par exemple obtenu par un procédé de type Langmuir-Blodgett. Le dépôt obtenu par un procédé de type Langmuir-Blodgett est un dépôt compact, i.e. chaque bille est en contact dans le plan avec six autres billes formant un arrangement hexagonal. On prévoit alors de réduire la compacité de la couche de billes, en réduisant la taille des billes par gravure sèche de type RIE (Reactive Ion Etching). Ainsi les billes ne sont plus en contact, ce qui permettra de réaliser des cavités non interconnectées. Si le dépôt des billes 26 permet un empilement non compact, selon par exemple une technologie de type « Shallow Trench Isolation » ou par la mise en oeuvre de micelles polymères ou copolymères, cette étape de réduction de la compacité n'est pas nécessaire.

Les billes sont par exemple en silice ou en polymère, par exemple en polystyrène, et présentent un diamètre compris entre 0,5 $\mu$m et 5 $\mu$m. Dans l'exemple représenté, il s'agit de billes, mais la mise en oeuvre d'éléments discrets présentant une forme quelconque ne sort pas du cadre de la présente invention.

Lors d'une étape suivante représentée sur la figure 5D, la couche 28, qui formera la plaque dans laquelle seront formées les cavités 8 et les conduits 10, est déposée sur les billes 26 et entre les billes de sorte à les recouvrir uniformément et à former des parois 13 entre les billes, qui une fois éliminées feront place à des cavités 8. D'une part, le matériau de la couche 28 est choisi de telle sorte qu'il puisse être gravé par gravure plasma, et d'autre part qu'il soit suffisamment rigide pour que la couche conserve son intégrité lorsque les billes 26 auront été supprimées, i.e. que la couche 28 ne s'effondre pas sur elle-même du fait de la porosité induite par la suppression des billes 26.

Le matériau de la couche 28 est choisi de préférence de sorte à offrir une faible mouillabilité vis-à-vis du liquide de refroidissement, i.e. de sorte à être hydrophobe dans le cas de l'eau, pour favoriser l'apparition de germe de vapeur.

Par exemple, la couche 28 est du type DLC déposé par un dépôt chimique en phase vapeur ou un dépôt physique en phase vapeur. Le DLC est hydrophile, cependant il présente l'avantage d'une grande sélectivité chimique par rapport à la silice, lui permettant de résister à la dissolution des billes de silice par l'acide fluorhydrique, comme nous le verrons par la suite.

La couche 28 présente par exemple une épaisseur permettant la réalisation de conduit de hauteur H telle que définie précédemment, H étant supérieur à $D_2$. La couche 28 n'a pas nécessairement une épaisseur constante, d'ailleurs un profil ondulé tel que visible sur la figure 5D permet d'augmenter la surface d'échange thermique.

Dans le cas de billes en polymère, un masque dur supplémentaire en SiC et d'épaisseur inférieure à 100 nm est avantageusement déposée sur les billes 26 avant le dépôt de la couche 26, empêchant la disparition des billes lors de la réalisation des conduits 10 par gravure de la couche 28.

Lors d'une étape suivante représentée sur la figure 5E, on effectue de nouveau un dépôt de billes 30 sur la couche 28, celles-ci ayant un diamètre inférieur ou égal à celui des billes 26. Le dépôt s'effectue de manière similaire à celui des billes 26.

Si le dépôt est compact, une étape de réduction de la compacité est effectuée.

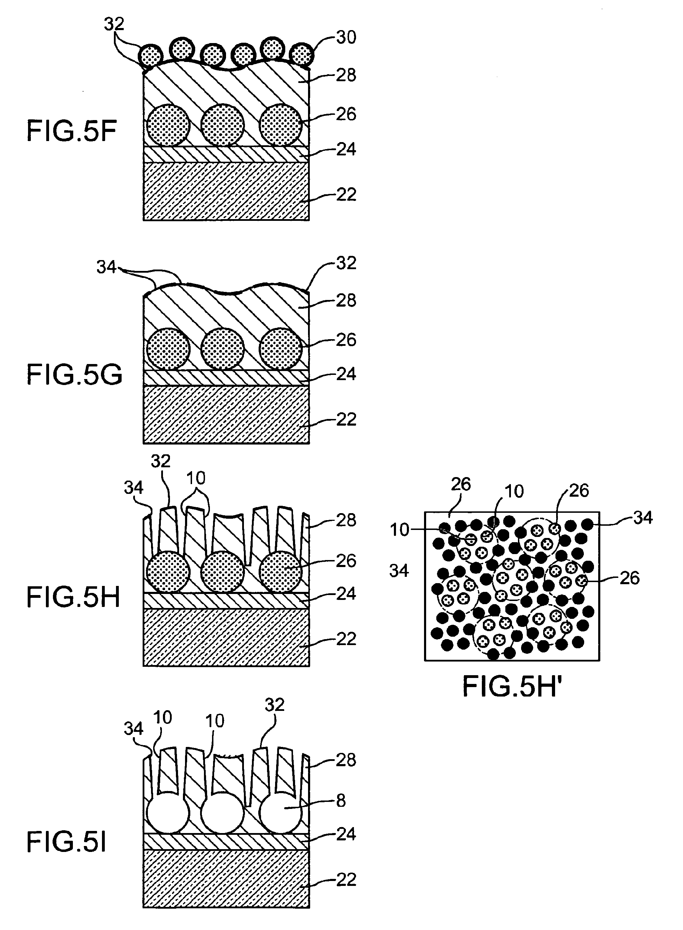

Lors d'une étape suivante représentée sur la figure 5F, une couche 32 continue est déposée sur la couche de billes 30 et sur les zones de la couche 28 entre les billes. Cette couche présente une épaisseur très faible par rapport au diamètre de billes de sorte à permettre le retrait des billes par exemple dans un bain à ultra-son dans une étape ultérieure.

La couche 32 est choisie de sorte à présenter une sélectivité importante par rapport au matériau de la couche 28, le DLC dans l'exemple donné, au mode de gravure qui sera utilisé pour graver la couche 28. Dans le cas présent, il s'agit de la gravure par plasma oxygène.

Cette couche est choisie de préférence pour offrir une bonne mouillabilité vis-à-vis du liquide de refroidissement. Ainsi il ne sera pas nécessaire de la supprimer puisque c'est elle qui sera finalement en contact du liquide de refroidissement. Cependant on pourrait prévoir une couche 32 qui serait supprimée après la réalisation des conduits 10.

Par exemple, la couche 32 est en silice, déposée par dépôt chimique en phase vapeur ou par dépôt physique en phase vapeur.

Lors d'une étape suivante représentée sur la figure 5G, les billes 30 sont éliminées, cette élimination est obtenue en appliquant des ultrasons dans un bain d'eau désionisée. On obtient alors une couche 32 percée de lumières 34 à l'emplacement des billes 32, ces lumières 34 donnant accès à la couche 28.

Lors d'une étape suivante représentée sur la figure 5H, on réalise les conduits 10. Pour cela, on grave la couche 28 par voie sèche par un plasma au niveau des lumières 34 jusqu'aux billes 26. Dans le cas où la couche 28 est en DLC et les billes 26 sont en silice, on peut choisir un plasma d'oxygène qui procure une sélectivité suffisante pour graver la couche 28 sans graver les billes 26 en silice. Dans le cas où la couche 28 est en DLC et les billes 26 en polymère, on choisit un plasma fluoré pour ouvrir la couche 28 et on poursuit avec un plasma oxygène. Certains conduits 10 débouchent sur des billes 26 tandis que d'autres non.

On obtient alors les conduits 10 qui relient la face 6 aux billes 26.

Dans le cas où l'épaisseur de la couche 32 est faible, il est avantageux de faire des conduits de forme tronconique, ce qui permet d'obtenir une meilleure robustesse de la structure formée des conduits 10.

Sur la figure 5H', on peut voir une vue de dessus de l'objet obtenu à cette étape, les lumières 34 se prolongeant chacune par un conduit 10. Au fond de certains conduits 10, des billes 26 sont visibles.

Lors d'une étape suivante, on supprime les billes 26. Cette suppression est obtenue par dissolution dans un bain. Dans le cas des billes en silice, il s'agit d'un bain à base d'acide fluorhydrique, et dans le cas des billes en polystyrène d'un bain d'acide chlorhydrique. L'objet final obtenu est visible sur la figure 5I. Seules les billes découvertes par la réalisation des conduits 10 sont dissoutes, les autres billes restant inaccessibles.

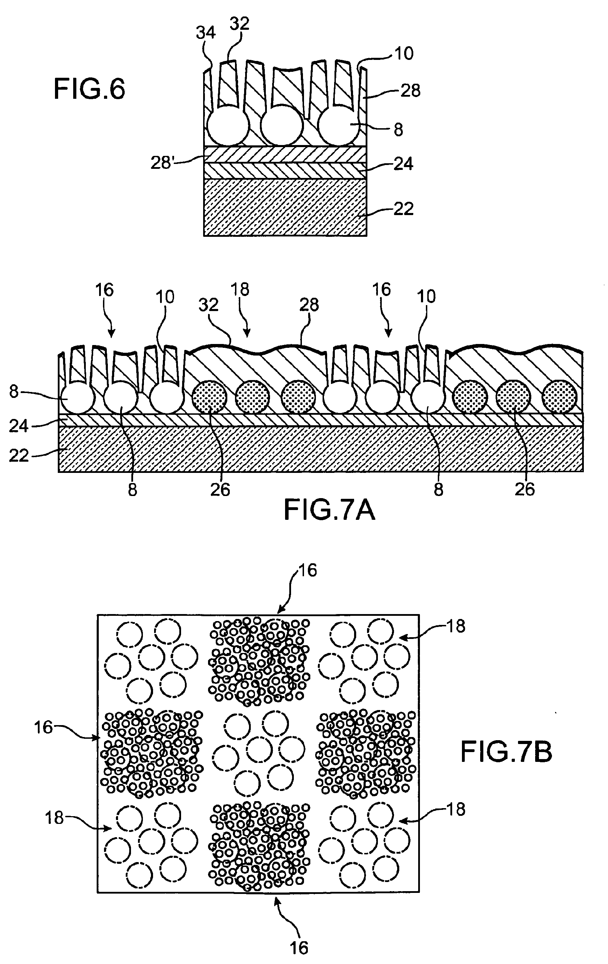

On peut prévoir, pour protéger la couche barrière, de déposer préalablement à la couche de billes, une couche 28' de DLC comme cela est visible sur la figure 6, les billes ne sont alors pas en contact avec la couche barrière.

Comme décrit précédemment, il peut être souhaitable de localiser les zones structurées 16. Sur la figure 7A, on peut voir un exemple d'une telle structure. Les zones structurées 16 sont séparées par des zones non structurées 18.

Cette localisation peut être obtenue en disposant sur la couche 32 des masques sur les zones que l'on ne veut pas structurer. Les billes 30 non couvertes par un masque sont supprimées au moyen d'un laser de type excimer, de manière collective et simultanément. Ce type de laser offre une résolution de l'ordre de quelques micromètres, ce qui permet de localiser les zones structurées mesurant au moins une dizaine de micromètres.

Les étapes de réalisation des conduits 10 et des cavités 8 sont similaires à celles décrites précédemment .

La distance $d_1$ entre deux zones est comprise entre 50 $\mu$m et 500 $\mu$m et la largeur $d_2$ d'une zone structurée est comprise entre 10 $\mu$m et 50 $\mu$m.

Sur la figure 7B, on peut voir une vue de dessus de la structure de la figure 7A. Le contour des cavités 8 est représenté en pointillés, ainsi que celui des billes 30 qui sont enterrées.

Le dispositif selon la présente invention peut s'appliquer à des échangeurs thermiques diphasiques, à des thermosiphons diphasiques, à des caloducs et plus généralement à des échangeurs thermiques faisant intervenir un changement de phases.

**Revendications**

1.  Dispositif d'échange thermique comportant une première face (4) destinée à être en contact avec une source de chaleur à évacuer et une deuxième face (6) destinée à être en contact avec un liquide de refroidissement, ledit dispositif comportant dans son épaisseur entre la première (4) et la deuxième (6) face, une pluralité de cavités (8) de rayon moyen (D1) , dans lequel : la dimension transversale du conduit au niveau de la connexion avec la cavité (8) est choisie de sorte à former une restriction entre la cavité (8) et le conduit (10), la deuxième face (6) étant percée d'orifices (11) formés par les conduits (10), **caractérisé en ce que**:

    - lesdites cavités (8) sont isolées les unes des autres de manière fluidique par des parois (13), chaque cavité (8) débouchant dans la deuxième face (6) par au moins un conduit (10), chaque conduit (10) présentant une longueur (H) supérieure au rayon moyen ($D_2$) des conduits (10),
    - ladite deuxième face (6) présente des propriétés de bonne mouillabilité vis-à-vis du liquide de refroidissement telle que l'angle de contact du liquide soit inférieur à 90° et l'angle de contact entre le liquide et les surfaces intérieures des conduits (10) et des cavités (8) est supérieur ou égal à celui entre le liquide et la deuxième face (6).

2.  Dispositif d'échange thermique selon la revendication 1, dans lequel les conduits (10) présentent un diamètre ($D_2$) maximal compris entre $0,1D_1$ et $D_1$ et dans lequel le nombre (n) de conduits (10) est défini tel que $n > 0,5 \times (D_1/D_2)^2$.

3.  Dispositif d'échange thermique selon la revendication 1 ou 2, dans lequel

$$V_{total\ conduits} > (P/P_{atm}) \times V_{cavité,}$$

    - $V_{total}$ conduits étant le volume formé par la somme des volumes de chacun des conduits (10) pénétrant dans une cavité (8),
    - $V_{cavité}$ étant le volume d'une cavité (8),
    - P étant la pression absolue de liquide de refroidissement,
    - $P_{atm}$ étant la pression atmosphérique.

4.  Dispositif selon l'une des revendications 1 à 3, dans lequel les parois (13) séparant les cavités (8) présentent une épaisseur minimale comprise entre 0,1 fois et 0,2 fois le diamètre moyen ($D_1$) des cavités, et les orifices (11) formés dans la deuxième face (6) sont séparés d'une distance ($L_2$) faible par rapport au diamètre des orifices (11).

5.  Dispositif d'échange thermique selon l'une des revendications 1à 4, dans lequel les conduits (10) présentent une forme tronconique dont la plus petite base est située au niveau de la connexion avec les cavités (8).

6.  Dispositif d'échange thermique selon l'une des revendications 1 à 5, comportant une matrice dans laquelle les cavités (8) et les conduits (10) sont réalisés et une couche (32) déposée sur la deuxième face (6), ladite matrice présentant une faible mouillabilité vis-à-vis du liquide et ladite couche (32) présentant une bonne mouillabilité vis-à-vis du liquide.

7.  Dispositif d'échange thermique selon l'une des revendications 1 à 6, comportant des zones munies d'orifices (11) formés par les conduits (10) débouchant dans la deuxième face (6), dites zones structurées (16), et des zones exemptes d'orifices (11), dites zones non structurées (18).

8.  Dispositif d'échange thermique selon la revendication précédente, dans lequel les zones structurées (16) ont un côté mesurant entre 10 $\mu$m et 50 $\mu$m, lesdits zones (16) étant séparées les unes des autres d'une distance comprise entre 50 $\mu$m et 500 $\mu$m.

9.  Procédé de réalisation d'un dispositif d'échange thermique selon l'une des revendications précédente, dans lequel les cavités (8) sont obtenues par le dépôt d'éléments discrets (26) sur un substrat, par enfouissement des ces éléments discrets dans une couche (28) de matériau formant la matrice du dispositif d'échange thermique, de réalisation dans la matrice de conduits (10) jusqu'aux éléments discrets (26) et d'élimination desdits éléments discrets (26).

**10.** Procédé de réalisation d'un dispositif d'échange thermique selon la revendication 9, comportant les étapes de :

a) dépôt sur un substrat (22) d'une couche barrière (24),
b) dépôt d'une couche d'éléments discrets de plus grand diamètre moyen (26) destinées à délimiter les cavités (8),
c) dépôt d'une couche (28) sur et entre les éléments discrets de plus grand diamètre moyen (28), ladite couche (28) étant destinée à former la matrice du dispositif,
d) dépôt d'éléments discrets de plus petit diamètre moyen (30) sur la couche formant matrice (26),
e) dépôt d'une couche continue (32) sur et entre les éléments discrets de plus petit diamètre moyen (30),
f) retrait des éléments discrets de plus petit diamètre moyen (30) laissant apparaître des lumières (34) au niveau desquelles la couche formant matrice (28) est découverte,
g) réalisation des conduits (10) dans la couche formant matrice (32) au niveau des lumières (34) jusqu'aux éléments discrets de plus grand diamètre moyen (28),
h) suppression des éléments discrets de plus grand diamètre moyen (28).

**11.** Procédé de réalisation d'un dispositif d'échange thermique selon la revendication 9 ou 10, dans lequel les éléments discrets (26, 30) sont en silice ou en polymère, par exemple en polystyrène, et la suppression des éléments discrets (26, 30) est obtenue par dissolution de ceux-ci par attaque chimique.

**12.** Procédé de réalisation d'un dispositif d'échange thermique selon la revendication 10 ou 11, dans lequel les éléments discrets de plus petit diamètre moyen (30) ont un diamètre moyen inférieur ou égal au diamètre moyen des éléments discrets de plus grand diamètre (26).

**13.** Procédé de réalisation d'un dispositif d'échange thermique selon la revendication 10, 11 ou 12, comportant une étape de réduction de la taille des éléments discrets de plus grand diamètre moyen (26) avant l'étape c) le dépôt et /ou une étape de réduction de la taille des éléments discrets de plus petit diamètre moyen (30) avant l'étape e), par exemple par gravure sèche.

**14.** Procédé de réalisation d'un dispositif d'échange thermique selon l'une des revendications 10 à 13, dans lequel la couche déposée à l'étape e) présente une bonne mouillabilité vis-à-vis du liquide de refroidissement, par exemple de la silice.

**15.** Procédé de réalisation d'un dispositif d'échange thermique selon l'une des revendications 10 à 14, dans lequel le matériau formant la matrice est du carbone amorphe hydrogéné.

**16.** Procédé de réalisation d'un dispositif d'échange thermique selon l'une des revendications 10 à 15, comportant préalablement à l'étape b), une étape de dépôt d'une précouche du matériau formant la matrice.

**17.** Procédé de réalisation d'un dispositif d'échange thermique selon l'une des revendications 10 à 16, comportant une étape de mise en place d'un masque sur l'empilement avant l'étape f) de retrait des éléments discrets de plus petit diamètre (30) de sorte à ne permettre un retrait des éléments discrets de plus petit diamètre moyen (30) qu'au niveau des zones non masquées.

**Claims**

**1.** A thermal exchange device comprising a first face (4) intended to be in contact with a source of heat to be dissipated, and a second face (6) intended to be in contact with a cooling liquid, said device comprising, all the way through it, between the first (4) and second (6) faces, multiple cavities (8) of average radius (D1), in which the transverse dimension of the duct in the area of the connection with the cavity (8) is chosen such that it forms a restriction between the cavity (8) and the duct (10), the second face (6) being pierced with apertures (11) formed by the ducts (10), **characterized in that**,

- said cavities (8) are isolated from one another in a fluid manner by walls (13) , where each cavity (8) emerges in the second face (6) through at least one duct (10), where the length (H) of each duct (10) is greater than the average radius ($D_2$) of the ducts,

- said second face (6) has properties of good wettability in relation to the cooling liquid, such that the contact angle of the liquid is less than 90° and the contact angle between the liquid and the inner surfaces of the ducts (10) and cavities (8) is greater than or equal to that between the liquid and the second face (6).

2. A thermal exchange device according to clam 1, in which the ducts (10) have a maximum diameter ($D_2$) between $0.1D_1$ and $D_1$, and in which the number (n) of ducts (10) is defined such that $n > 0.5 \times (D_1/D_2)^2$.

3. A thermal exchange device according to claim 1 or 2, in which

$$V_{total\ ducts} > (P/P_{atm}) \times V_{cavity,}$$

- $V_{total\ ducts}$ being the volume formed by the sum of the volumes of each of the ducts (10) penetrating into a cavity (8),
- $V_{cavity}$ being the volume of a cavity (8),
- P being the absolute pressure of the cooling liquid,
- and $P_{atm}$ being the atmospheric pressure.

4. A device according to one of the claims 1 to 3, in which the walls (13) separating the cavities (8) have a minimum thickness of between 0.1 times and 0.2 times the average diameter ($D_1$) of the cavities, and the apertures (11) formed in the second face (6) are separated by a small distance ($L_2$) compared to the diameter of the apertures (11).

5. A thermal exchange device according to one of the claims 1 to 4, in which the ducts (10) have a tapered shape, in which the smaller base is located in the area of the connection with the cavities (8).

6. A thermal exchange device according to one of the claims 1 to 5, comprising a matrix in which the cavities (8) and the ducts (10) are produced and a layer (32) deposited on the second face (6), said matrix having a low wettability in relation to the liquid and said layer (32) having a good wettability in relation to the liquid.

7. A thermal exchange device according to one of the claims 1 to 6, comprising areas with apertures (11) formed by the ducts (10) emerging in the second face (6), called structured areas (16), and areas without apertures (11), called unstructured areas (18).

8. A thermal exchange device according to the previous claim, in which the structured areas (16) have a side measuring between 10 $\mu$m and 50 $\mu$m, said areas (16) being separated from one another by a distance of between 50 $\mu$m and 500 $\mu$m.

9. A method for production of a thermal exchange device according to one of the previous claims, in which the cavities (8) are obtained by the deposit of discrete elements (26) on a substrate, by burying these discrete elements in a layer (28) of material forming the matrix of the thermal exchange device, in order to produce in the matrix of ducts (10) until reaching the discrete elements (26), and to eliminate said discrete elements (26).

10. A method for production of a thermal exchange device according to claim 9, comprising the steps of:

a) deposit on a substrate (22) of a barrier layer (24),
b) deposit of a layer of discrete elements of greater average diameter (26) , intended to demarcate the cavities,
c) deposit of a layer (28) on and between the discrete elements of greater average diameter (28), said layer (28) being intended to form the matrix of the device,
d) deposit of discrete elements of smaller average diameter (30) on the layer forming the matrix (26),
e) deposit of a continuous layer (32) on and between the discrete elements of smaller average diameter (30),
f) removal of the discrete elements of smaller average diameter (30) revealing apertures (34) in the areas of which the layer forming the matrix (28) is exposed,
g) production of ducts (10) in the layer forming the matrix (32) in the area of the apertures (34) until reaching the discrete elements of greater average diameter (28),
h) elimination of the discrete elements of greater average diameter (28) .

**11.** A method for production of a thermal exchange device according to claim 9 or 10, in which the discrete elements (26, 30) are made of silica or polymer, for example polystyrene, and the discrete elements (26, 30) are eliminated by dissolution of them by chemical attack.

**12.** A method for production of a thermal exchange device according to claim 10 or 11, in which the discrete elements of smaller average diameter (30) have an average diameter less than or equal to the average diameter of the discrete elements of larger diameter (26).

**13.** A method for production of a thermal exchange device according to claim 10, 11 or 12, comprising a step of reduction of the size of the discrete elements of greater average diameter (26) before step c) deposit and/or a step of reduction of the size of the discrete elements of smaller average diameter (30) before step e), for example by dry etching.

**14.** A method for production of a thermal exchange device according to one of the claims 10 to 13, in which the layer deposited in step e) has good wettability in relation to the cooling liquid, for example silica.

**15.** A method for production of a thermal exchange device according to one of the claims 10 to 14, in which the material forming the matrix is hydrogenated amorphous carbon.

**16.** A method for production of a thermal exchange device according to one of the claims 10 to 15, comprising, before step b), a step of deposit of a preliminary layer of material forming the matrix.

**17.** A method for production of a thermal exchange device according to one of the claims 10 to 16, comprising a step of installation of a mask on the stack before step f) of removal of the discrete elements of smaller diameter (30), so as to allow the discrete elements of smaller average diameter (30) to be removed only in the area of the unmasked areas.

**Patentansprüche**

**1.** Wärmeaustauscher-Vorrichtung, welche eine erste zum Kontakt mit einer Quelle abzuführender Wärme bestimmte Seite bzw. Oberfläche (4) und eine zweite zum Kontakt mit einer Kühlflüssigkeit bestimmte Seite bzw. Oberfläche (6) umfasst und in ihrer Dicke zwischen der ersten Seite (4) und der zweiten Seite (6) eine Mehr- bzw. Vielzahl von Ausnehmungen bzw. Hohlräumen (8) von mittlerem Radius (D1) aufweist,
wobei die Querabmessung des Kanals im Bereich der Verbindung mit dem Hohlraum (8) so gewählt ist, dass sie eine Einengung bzw. Engstelle zwischen dem Hohlraum (8) und dem Kanal (10) bildet, und wobei die zweite Seite bzw. Oberfläche (6) von durch die Kanäle (10) gebildeten Mündungsöffnungen durchsetzt ist, **dadurch gekennzeichnet, dass**

-- die genannten Ausnehmungen bzw. Hohlräume (8) strömungsmäßig voneinander durch Wandungen (13) getrennt sind und jeder Hohlraum (8) jeweils über wenigstens einen Kanal (10) in der zweiten Seite bzw. Oberfläche (6) mündet, wobei jeder Kanal (10) jeweils eine Länge (H) aufweist, die größer als der mittlere oder durchschnittliche Radius (D2) der Kanäle (10) ist
-- und dass die zweite Seite bzw. Oberfläche (6) Eigenschaften guter Benetzbarkeit gegenüber der Kühlflüssigkeit aufweist, derart dass der Kontaktwinkel der Flüssigkeit kleiner als 90° ist und der Kontaktwinkel zwischen der Flüssigkeit und den Innenoberflächen der Kanäle (10) und der Ausnehmungen bzw. Hohlräume (8) größer als oder gleich dem Kontaktwinkel zwischen der Flüssigkeit und der zweiten Seite bzw. Oberfläche (6) ist.

**2.** Wärmeaustauscher-Vorrichtung nach Anspruch 1, bei welcher die Kanäle (10) einen maximalen Durchmesser (D2) im Bereich zwischen 0,1 $D_1$ und $D_1$ besitzen und in welcher die Anzahl (n) der Kanäle (10) durch $n > 0,5 \times (D_1/D_2)^2$ definiert ist.

**3.** Wärmeaustauscher-Vorrichtung nach Anspruch 1 oder 2, bei welcher

$$V_{total\ conduits} > (P/P_{atm}) \times V_{cavité},$$

worin

-- $V_{total}$ conduits das von der Summe der Volumina jedes der in einen Hohlraum mündenden Kanäle gebildete Volumen ist,
-- $V_{cavité}$ das Volumen einer Ausnehmung bzw. eines Hohlraums (8) ist,
-- P der Absolutdruck der Kühlflüssigkeit ist ,
-- $P_{atm}$ der atmosphärische Luftdruck ist.

4. Vorrichtung nach einem der Ansprüche 1 bis 3, in welcher die die Hohlräume (8) trennenden Wandungen eine minimale Dicke im Bereich zwischen dem 0,1-fachen und dem 0,2 -fachen des mittleren oder durchschnittlichen Durchmessers ($D_1$) der Hohlräume aufweise und die in der zweiten Seite bzw. Oberfläche (6) gebildeten Mündungsöffnungen (11) durch einen Abstand ($L_2$) getrennt sind, der klein im Vergleich zum Durchmesser der Mündungsöffnungen (11) ist.

5. Wärmeaustauscher-Vorrichtung nach einem der Ansprüche 1 bis 4, in welcher die Kanäle (10) kegelstumpfförmig ausgebildet sind, wobei die kleinere Grundfläche auf dem Niveau der Verbindung mit den Hohlräumen (8) angeordnet ist.

6. Wärmeaustauscher-Vorrichtung nach einem der Ansprüche 1 bis 5, welche eine Matrix umfasst, in welcher die Hohlräume (8) und die Kanäle (10) ausgebildet sind und auf der zweiten Seite bzw. Oberfläche (6) eine Schicht (32) abgeschieden ist, wobei die Matrix eine geringe Benetzbarkeit und die Schicht (32) eine gute Benetzbarkeit bezüglich der Flüssigkeit aufweist.

7. Wärmeaustauscher-Vorrichtung nach einem der Ansprüche 1 bis 6, welche mit Mündungsöffnungen (11) versehene Zonen umfasst, die von an der zweiten Seite bzw. Oberfläche (6) mündenden Kanälen (10) gebildet werden und als strukturierte Zonen (16) bezeichnet werden, sowie von Mündungsöffnungen (11) freie Zonen, die als nicht strukturierte Zonen (18) bezeichnet werden.

8. Wärmeaustauscher-Vorrichtung nach dem vorstehenden Anspruch, bei welcher die strukturierten Zonen (16) eine zwischen 10 $\mu$m und 50 $\mu$m messende Seite besitzen, wobei die genannten Zonen (18) voneinander durch einen Abstand im Bereich zwischen 50 $\mu$m und 500 $\mu$m getrennt sind.

9. Verfahren zur Erstellung einer Wärmeaustauscher-Vorrichtung nach einem der vorhergehenden Ansprüche, bei welchem die Ausmehmungen bzw. Hohlräume (8) durch Abscheiden diskreter Elemente (26) auf einem Substrat erhalten werden mittels Einbettung dieser diskreten Elemente in einer Schicht (28) aus die Matrix der Wärmeaustauscher-Vorrichtung bildendem Material, sowie zur Herstellung von Kanäle (10) in der Matrix bis zu den diskreten Elementen (26), und zur Entfernung der diskreten Elemente (26).

10. Verfahren zur Herstellung einer Wärmeaustauscher-Vorrichtung nach Anspruch 9, wobei das Verfahren die folgenden Stufen bzw. Schritte umfasst:

a) Abscheiden einer Barriere- bzw. Sperrschicht (24) auf einem Substrat (22),
b) Abscheiden einer Schicht diskreter Elemente (26) größeren mittleren oder durchschnittlichen Durchmessers, die zur Begrenzung der Ausnehmungen bzw. Hohlräume (8) bestimmt sind,
c) Abscheiden einer Schicht (28) auf und zwischen den diskreten Elementen (28) größeren mittleren oder durchschnittlichen Durchmessers, wobei die Schicht (28) zur Bildung der Matrix der Vorrichtung bestimmt ist,
d) Abscheiden diskreter Elemente (30) kleineren mittleren oder durchschnittlichen Durchmessers, auf der die Matrix bildenden Schicht (26),
e) Abscheiden einer kontinuierlichen Schicht (32) auf und zwischen den diskreten Elementen (30) kleineren mittleren oder durchschnittlichen Durchmessers,
f) Rückbilden bzw. Entfernen der diskreten Elemente (30) kleineren mittleren bzw. durchschnittlichen Durchmessers, mit auftretenden Leerstellen bzw. Freiflächen (34), an denen die die Matrix (28) bildende Schicht freigelegt ist,
g) Herstellung der Kanäle (10) in der Matrixbildenden Schicht (32) im Bereich der Leerstellen bzw. Freiflächen (34), bis zu den diskreten Elementen (28) größeren mittleren oder durchschnittlichen Durchmessers,
h) Beseitigen der diskreten Elemente (28) größeren mittleren bzw. durchschnittlichen Durchmessers.

11. Verfahren zur Herstellung einer Wärmeaustauscher-Vorrichtung nach Anspruch 9 oder 10, bei welchem die diskreten Elemente (26, 30) aus Siliziumoxyd oder aus Polymermaterial, beispielsweise aus Polystyrol, bestehen, und bei welchem die Entfernung der diskreten Elemente (26, 30) durch deren Auflösen mittels chemischer Einwirkung erfolgt.

12. Verfahren zur Herstellung einer Wärmeaustauscher-Vorrichtung nach Anspruch 10 oder 11, bei welchem die diskreten Elemente (30) kleineren mittleren Durchmessers einen mittleren oder durchschnittlichen Durchmesser besitzen, der kleiner als oder gleich dem mittleren oder durchschnittlichen Durchmesser der diskreten Elemente (26) größeren Durchmessers ist.

13. Verfahren zur Herstellung einer Wärmeaustauscher-Vorrichtung nach Anspruch 10, 11 oder 12, welches einen Schritt der Abmessungsverringerung der diskreten Elemente (26) größeren mittleren oder durchschnittlichen Durchmessers vor dem Verfahrensschritt c) der Abscheidung und/oder einen Schritt der Abmessungsverringerung der diskreten Elemente (30) kleineren mittleren Durchmessers vor dem Schritt e) umfasst, beispielsweise mittels trockener Ätzung.

14. Verfahren zur Herstellung einer Wärmeaustauscher-Vorrichtung nach einem der Ansprüche 10 bis 13, bei welchem die im Schritt e) abgeschiedene Schicht eine gute Benetzbarkeit seitens der Kühlflüssigkeit aufweist und beispielsweise aus Siliziumoxid besteht.

15. Verfahren zur Herstellung einer Wärmeaustauscher-Vorrichtung nach einem der Ansprüche 10 bis 14, bei welchem das die Matrix bildende Material amorpher Kohlenstoff mit einem Wasserstoffgehalt ist.

16. Verfahren zur Herstellung einer Wärmeaustauscher-Vorrichtung nach einem der Ansprüche 10 bis 15, das vor dem Schritt b) einen Verfahrensschritt der Abscheidung eines Vorläufers des die Matrix bildenden Materials umfasst.

17. Verfahren zur Herstellung einer Wärmeaustauscher-Vorrichtung nach einem der Ansprüche 10 bis 16, das einen Verfahrensschritt der Anbringung einer Maske auf dem Schichtstapel vor dem Schritt f) der Entfernung bzw. Rückbildung der diskreten Elemente (30) kleineren Durchmessers umfasst, derart dass eine Entfernung bzw. Rückbildung der diskreten Elemente (30) kleineren mittleren oder durchschnittlichen Durchmessers nur im Bereich der nicht maskieren Zonen stattfinden kann.

FIG.1A

FIG.1B

FIG.2

FIG.3A

FIG.3B

FIG.3C

FIG.4

FIG.5A

— 22

FIG.5B

— 24
— 22

FIG.5C

— 26
— 24
— 22

FIG.5D

— 28
— 26
— 24
— 22

FIG.5E

— 30
— 28
— 26
— 24
— 22

FIG.5F

FIG.5G

FIG.5H

FIG.5H'

FIG.5I

FIG.6

FIG.7A

FIG.7B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2008090726 A

**Littérature non-brevet citée dans la description**

- **ANISH TUTEJA.** Designing Superoleophobic Surfaces. *Science,* 2007, vol. 318 (1618), 1619-1622

- Nucleate Pool Boiling on Structured Enhanced Tubes having Pores with Connecting Gaps. Nae-Hyun Kim, Kuk-Kwang Cj oi. Taylor & Francis, 2005